# EUROPEAN PATENT SPECIFICATION

(11) **EP 2 258 889 B1**
(45) Date of publication and mention of the grant of the patent: **20.11.2019**
(21) Application number: 09252787.8
(22) Date of filing: 15.12.2009
(51) Int. Cl.: C23C 14/08, C23C 14/50

(54) **Method and apparatus for applying a thermal barrier coating**
Verfahren und Vorrichtung zum Auftragen einer Wärmedämmbeschichtung
Procédé et appareillage d'application d'un revêtement de barrière thermique

(30) Priority: 01.06.2009 US 475913
(43) Date of publication of application: 08.12.2010
(73) Proprietor: United Technologies Corporation, Farmington, CT 06032 (US)
(72) Inventor: Zimmerman, Benjamin J., Enfield, CT 06082 (US); Blondin, John F., South Windsor CT 06074 (US); Litton, David A., West Hartford, CT 06107 (US)
(74) Representative: Dehns

(56) References cited:
- EP-A1- 1 762 634
- US-A- 6 054 184
- US-A1- 2009 075 024
- US-B1- 6 333 090

## Description

### BACKGROUND

The disclosure relates gas turbine engines. More particularly, the disclosure relates to thermal barrier coatings for gas turbine engines.

Gas turbine engine gaspath components are exposed to extreme heat and thermal gradients during various phases of engine operation. Thermal-mechanical stresses and resulting fatigue contribute to component failure. Significant efforts are made to cool such components and provide thermal barrier coatings to improve durability.

Exemplary thermal barrier coating systems include two-layer thermal barrier coating systems. An exemplary system includes NiCoCrAlY bond coat (e.g., low pressure plasma sprayed (LPPS)) and a yttria-stabilized zirconia (YSZ) thermal barrier coat (TBC) (e.g., air plasma sprayed (APS) or electron beam physical vapor deposited (EBPVD)). Prior to and while the barrier coat layer is being deposited, a thermally grown oxide (TGO) layer (e.g., alumina) forms atop the bond coat layer. As time-at-temperature and the number of cycles increase, this TGO interface layer grows in thickness. US Patents 4,405,659 and 6,060,177 disclose exemplary systems.

Exemplary TBCs are applied to thicknesses of 5-40 mils (0.1-1.0mm) and can contribute to a temperature reduction of the base beta of up to 300°F temperature reduction to the base metal. This temperature reduction translates into improved part durability, higher turbine operating temperatures, and improved turbine efficiency.

A method having the features of the preamble of claim 1 is disclosed in US-A-6054184 or US2009/0075024.

### SUMMARY

One aspect of the invention involves a method for coating a gas turbine engine component, as set forth in claim 1.

A bond coat may be applied to a substrate of the component and the barrier coat applied atop the bond coat.

In various implementations, the method may be implemented in the remanufacturing of a baseline component or the reengineering thereof. The baseline component may have a barrier coat which was applied at a single rotational speed and has a corresponding microstructure.

The details of one or more embodiments are set forth in the accompanying drawings and the description below. Other features, objects, and advantages will be apparent from the description and drawings, and from the claims.

### BRIEF DESCRIPTION OF THE DRAWINGS

FIG. 1 is a partially schematic sectional view of coated substrate.
FIG. 2 is a flowchart of a process for coating the substrate of FIG. 1.
FIG. 3 is a partially schematic view of an apparatus for applying a thermal barrier coating to the substrate.
FIG. 4 is a sectional electronmicrograph of a coated substrate.
FIG. 5 is a sectional electronmicrograph of a baseline coated substrate.

Like reference numbers and designations in the various drawings indicate like elements.

### DETAILED DESCRIPTION

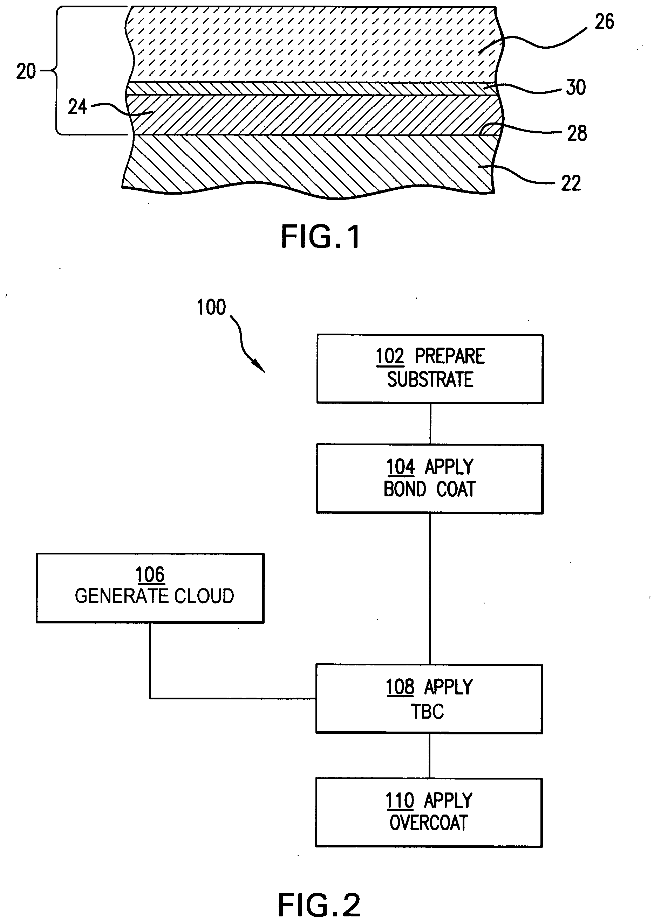

FIG. 1 shows a coating system 20 atop a superalloy substrate 22. The system may include a bond coat 24 atop a surface 28 of the substrate 22 and a TBC 26 atop the bond coat 24. A TGO 30 may form at the interface of the bondcoat to the TBC.

In an exemplary embodiment, the substrate is a cast component of a gas turbine engine. Exemplary components are hot section components such as combustor panels, turbine blades, turbine vanes, and air seals. Exemplary substrate materials are cobalt-based superalloys or nickel-based superalloys. In an exemplary method, the cast substrate is cleaned 102. The bond coat is then applied or deposited 104. One exemplary bond coat is a MCrAlY which may be deposited by a thermal spray process (e.g., air plasma spray or low pressure plasma spray) or by an electron beam physical vapor deposition (EBPVD) process such as described in US Patent 4,405,659. An alternative bond coat is a diffusion aluminide deposited by vapor phase aluminizing (VPA) as in US Patent 6,572,981. An exemplary characteristic (e.g., mean or median) bond coat thickness is 4-9mil (100-230µm).

In the exemplary embodiment, a ceramic vapor cloud is generated 106 causing the TBC is applied or deposited 108 from the cloud directly atop the exposed surface of the bond coat 24 or the pre-existing TGO 30. An exemplary TBC comprises rare-earth stabilized zirconia applied by electron beam physical vapor deposition (EBPVD), more particularly, yttria-stabilized zirconium oxide, also known as yttria-stabilized zirconia (YSZ) (e.g., 6-8% yttria by weight, with the nominal 7% yttria being designated 7YSZ). As is discussed further below, the substrate is rotated during TBC deposition. The speed of rotation may be varied to produce a TBC microstructure which has modified properties relative to a baseline TBC deposited at a single rotational speed.

An overcoat (if any) may then be applied 110. An exemplary overcoat is a chromia-alumina combination as disclosed in US Patent 6,060,177.

The modified barrier coating can be applied to a wide variety of bond coats. Such bond coats may be applied by air plasma-spray (APS), low pressure plasma-spray (LPPS), chemical vapor deposition, high velocity oxygen fuel (HVOF), flame spray, electron beam physical vapor deposition (EB-PVD), detonation spray, cathodic arc, and sputtering.

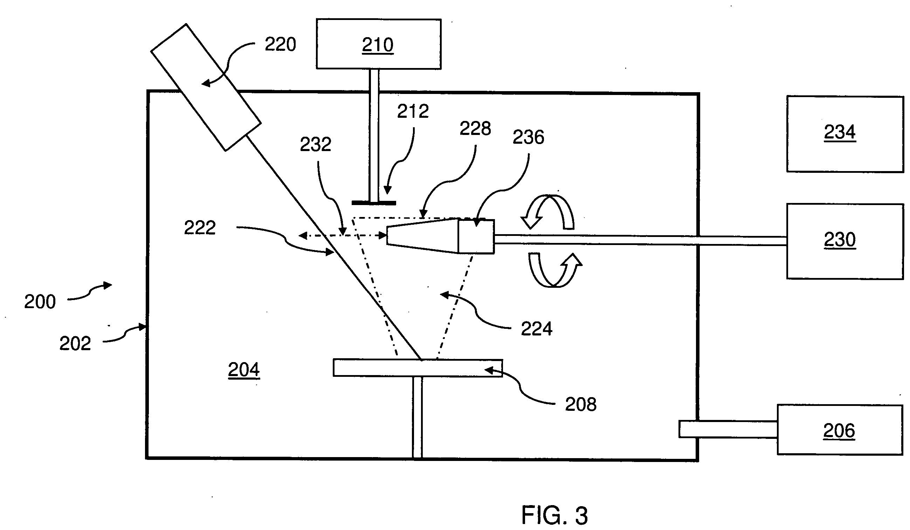

FIG. 3 shows an exemplary electron beam physical vapor deposition system 200 for depositing the TBC. The system 200 includes a vessel or chamber 202 having an interior 204. A vacuum pump 206 is coupled to the vessel to evacuate the interior. A ceramic target 208 is located in the interior. An oxygen source 210 may be positioned to introduce oxygen to the interior 204 via a manifold 212. An electron beam source 220 is positioned to direct an electron beam 222 to the target to vaporize a surface of the target to create a vapor cloud 224. A fixture or holder 236 is positioned in the chamber to hold a component (e.g., a turbine blade or vane) 228 exposed to the vapor cloud 224. The vapor cloud condenses on the component to form the TBC.

A motor 230 is coupled to the holder to rotate the holder and component about an axis 232. A controller 234 (e.g., a microcontroller, microcomputer, or the like) may be coupled to the motor, the electron beam source, the vacuum pump, oxygen source and/or any other appropriate components, sensors, input devices, and the like to control aspects of system operation. The exemplary controller may be programmed (e.g., via one or both of software and hardware) to vary a rotational speed of the holder and component about the axis during deposition.

The TBC is built up over the course of many rotations. By varying the rotational speed, the buildup at any given location on the component will be the result of passes at the different speeds. Each rotational pass builds up a small sublayer of the TBC (e.g., having a sublayer thickness of less than 10 micrometer, more narrowly 0.05-7.0 micrometer or, yet more narrowly 0.1-2.0 micrometer or 0.2-2.0 micrometer). In the examples of the table below, the rotational speed is alternated between a low speed and a high speed, each for a common angular interval. Although the exemplary intervals all less than 360 degrees, intervals of more than 360 degrees may be possible.

The deposition causes the buildup atop any given location on the component to be composed of regions having been deposited at combinations of the two different speeds. Depending upon the particular angular intervals chosen, these regions may be characterized by something as finely distributed as alternating single pass sublayers at each of the two speeds. Alternatively, various of the regions may be produced by contiguous groups of multiple passes at a given speed (e.g., to locally form one sublayer) alternating with contiguous groups of passes at the other speed(s) (to locally form one or more additional sublayers). Exemplary thicknesses for each of these sublayers is less than 8% of the total TBC thickness, more narrowly 0.005-6% or, yet more narrowly 0.02-2.6% or 0.7-2.0%. Alternatively characterized, of the total amount of TBC (either overall or at any given location) may be composed of at least 50% being characterized by having such layer thicknesses or having no single speed region of more than 5% of the total volume or local thickness. Exemplary overall local or average (mean or median) total TBC thickness is 3.0-12.0 mil (76 micrometer - 0.3 mm).

The low rate may consist essentially of a single speed or multiple speeds in a range of 1-30rpm while the high rate may consist essentially of a single speed or multiple speeds in a range of 5-100rpm. Alternatively described, the high rate may be 2-10 times the low rate. In one example, exemplary low speeds (rates) are no more than 10rpm while exemplary high speeds are at least 12rpm.

Speed change interval or frequency is at least once per revolution. In various examples, at least a tenth of the barrier coat may be deposited at the low speed or speed range and at least a third at the high speed or speed range.

**Examples**

| Example | Low Speed (RPM) | High Speed (RPM) | Interval (degrees) | Erosion Rate | Thermal Conductivity (Btu-in/ hr-ft2-°F) (W/mK) |
|---|---|---|---|---|---|
| 1 | 5 | 30 | 72 | 2.6 | 13.4 (1.93) |
| 2 | 2 | 30 | 72 | - | 11.9 (1.72) |
| 3 | 8 | 15 | 288 | 3.8 | 13.5 (1.95) |
| 4 | 2 | 15 | 288 | 3.5 | 12.5 (1.80) |
| Baseline | 30 | 30 | NA | 3.3 | 13.7 (1.98) |

Erosion was measured as grams of material loss per kilogram erodent when blasting with 27 micrometer alumina grit normal to the surface at a rate of 800ft/s(243m/s) and a temperature of 2000F (1093C). Thermal conductivity was measured at 2200F (1204C). Deposition parameters were as follows: test substrates were alumina coupons in lieu of a metallic substrate and bond coat; 7YSZ TBC deposition was performed to produce the TBC of 5mils (0.13mm) thickness. Approximate TBC deposition parameters were: a temperature of 1975F (1079C); a power of 77kW; a pressure of 6millitorr; and an oxygen flow rate of 900sccm. The 2200F (1204C) temperature was selected as a typical temperature for a thermal barrier coating during the hotter parts of a given engine/aircraft mission. The 2000F (1093C) erosion test temperature was selected because it was the upper limit of the test equipment.

From the table, it can be seen that erosion resistance is not substantially negatively affected (if at all) through the use of variable rotation rate whereas there is some reduction in thermal conductivity.

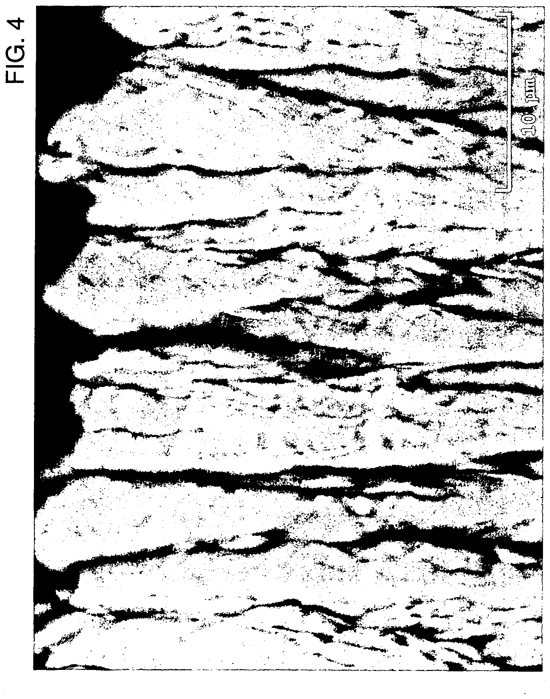

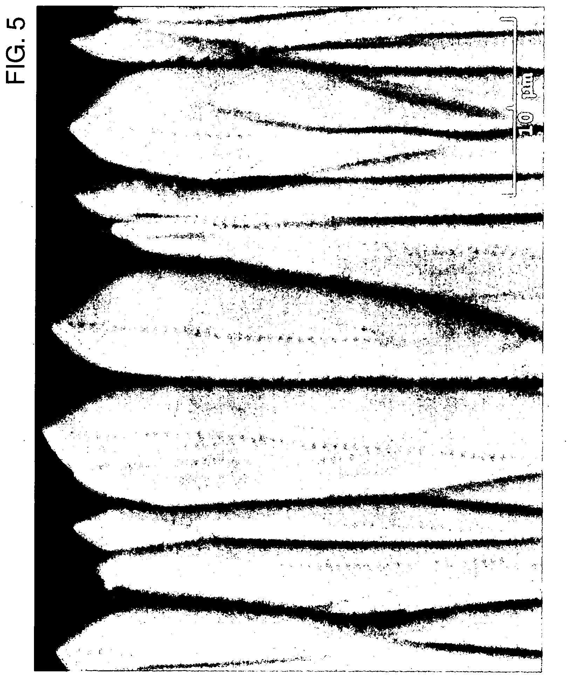

FIG. 4 is a sectional electromicrograph of Example 1. By contrast, FIG. 5 is a sectional electromicrograph of the baseline. It can be seen that the columnar microstructure in FIG. 4 is distorted due to the variable rotation rate. FIG. 5 shows a baseline clean columnar growth highly normal to the surface and linear. The highly constant layer thickness is seen in the equi-spaced dark spots on each column and in similar effects in the edge of the image of each column. FIG. 4 shows much greater differences than a mere variation in layer thickness. Although overall column growth is still fairly normal to the surface, localized growth varies in direction. This produces a columnar microstructure having layered variations in density, porosity and directionality. It also produces a ragged overall column shape. The ragged column shape can cause an interlocking of columns which may improve the mechanical properties of the coating. Specifically, the zig-zag microstructure is believed to offer a modulated density and directionality associated with the rotation changes so as to provide increased resistance to heat conduction and mechanical damage. Because the chemical composition remained a constant throughout the tested coating specimens, all variations in density for a specimen are due to changes in the microstructure (believed specifically due to the changes in the volume fraction of porosity between the various layers). The average density of all coating specimens was found to be within 10% of the baseline, but the local density within the various layers of the coatings would be expected to vary more. The exact magnitude of this variation was not determined.

A lower thermal conductivity may enable higher operating temperatures resulting in improved turbine efficiency. Improved erosion resistance in comparison to other reduced thermal conductivity coatings may yield longer component life for components in the combustor and turbine sections.

The coating may be applied to replace an existing baseline thermal barrier coating such as that of FIG. 5 which has a columnar microstructure having essentially constant density and directionality. The baseline TBC may be mechanically stripped prior to recoating.

Many variations are possible. For example, more than merely the two discrete speeds could be used. This includes the possibility of additional discrete speeds or a more continuous speed variation. In examples of continuous variation, relative times in different speed ranges or amounts of TBC deposited at those ranges may be substituted for the time intervals or amounts deposited at the discrete speeds. Additionally, although the same time interval is shown for each of the two speeds, different speeds might be associated with different intervals.

One or more embodiments have been described. Nevertheless, it will be understood that various modifications may be made without departing from the scope of the disclosure. For example, when applied as a reengineering of an existing component, details of the existing component may influence or dictate details of any particular implementation. Similarly, when applied as a modification of an existing process or with existing deposition equipment, details of the existing process or equipment may influence or dictate details of any particular implementation. Accordingly, other embodiments are within the scope of the following claims.

## Claims

1. A method for coating a gas turbine engine component (22), the method comprising:
applying a ceramic barrier coat (26) by means of electron beam physical vapor deposition,
wherein the applying of the barrier coat (22) comprises:
rotating the substrate (22) as the barrier coat (26) is applied; and
varying a speed of the rotation by alternating between a low rate and a high rate so that a buildup of the barrier coat at a given location on the component (228) is formed by passes at varied speed, **characterised in that**
the alternating occurs at least once per revolution.

2. The method of claim 1 wherein:
the low rate is no more than 10rpm and the high rate is at least 12rpm.

3. The method of claim 1 wherein:
the high rate is 2-10 times the low rate.

4. The method of claim 3 wherein:
the low rate consists of a single speed in a range of 1-30rpm and the high rate consists of a single speed in a range of 5-100rpm.

5. The method of claim 3 wherein:
the rotating consists of said low rate and said high rate.

6. The method of claim 1 wherein:
the varying comprises depositing at least a tenth of the barrier coat (26) at a speed of the rotation no more than 10rpm and at least a third of the barrier coat at a speed of the rotation of at least 12rpm.

7. The method of any preceding claim wherein:
the barrier coat (26) has a rare-earth based stabilized zirconia content of at least 50%, by weight.

8. The method of any preceding claim wherein:
the barrier coat (26) consists of 7YSZ.

9. The method of any preceding claim further comprising:
applying a bond coat (24) to a substrate (22) of the component and wherein the barrier coat (26) is applied atop the bond coat (24).

10. The method of claim 9 wherein:
the applying of the bond coat is by low pressure plasma spray (LPPS).

11. The method of claim 9 wherein:
the applying of the bond coat is by low pressure plasma spray (LPPS) of an NiCoCrAlY material; and
the applying of the barrier coat by electron beam physical vapor deposition (EBPVD) is of material comprising at least 50%, by weight, yttria-stabilized zirconia (YSZ).

12. The method of claim 9, 10 or 11 wherein the barrier coat (26) is **characterized by** a columnar microstructure having modulated density and directionality and further comprising:
removing a baseline thermal barrier coating having a structure **characterized by** a columnar microstructure of constant density and directionality.

13. An apparatus (200) comprising:
a fixture (236) for holding a component (228);
a motor (230) coupled to the fixture (236) for rotating the fixture (236) about a fixture axis (232);
an electron beam physical vapor deposition source (208) of a ceramic positioned to provide a vapor to the component (228) on the fixture (236); and
a controller (234) coupled to the motor (230) to control the rotation and configured to alternate a speed of the rotation between a low rate and a high rate so that a buildup of the ceramic at a given location on the component (228) is formed by passes at varied speed; **characterised in that** the alternating occurs at least once per revolution.

## Patentansprüche

1. Verfahren zum Beschichten einer Komponente (22) eines Gasturbinentriebwerks, wobei das Verfahren Folgendes umfasst:
Auftragen einer Keramiksperrschicht (26) mithilfe einer Elektronenstrahlverdampfung,
wobei das Auftragen der Sperrschicht (22) Folgendes umfasst:
Drehen des Substrats (22), wenn die Sperrschicht (26) aufgetragen wird; und
Ändern einer Drehzahl durch das Wechseln zwischen einer niedrigen Rate und einer hohen Rate, sodass ein Aufbau der Sperrschicht an einer gegebenen Stelle an der Komponente (228) durch Durchgänge mit unterschiedlicher Drehzahl gebildet wird, **dadurch gekennzeichnet, dass**
der Wechsel mindestens einmal pro Umdrehung auftritt.

2. Verfahren nach Anspruch 1, wobei:
die niedrige Rate nicht mehr als 10 U/min entspricht und die hohe Rate mindestens 12 U/min entspricht.

3. Verfahren nach Anspruch 1, wobei:
die hohe Rate dem 2-10-Fachen der niedrigen Rate entspricht.

4. Verfahren nach Anspruch 3, wobei:
die niedrige Rate aus einer einzigen Drehzahl in einem Bereich von 1-30 U/min besteht und die hohe Rate aus einer einzigen Drehzahl in einem Bereich von 5-100 U/min besteht.

5. Verfahren nach Anspruch 3, wobei:
die Drehung aus der niedrigen Rate und der hohen Rate besteht.

6. Verfahren nach Anspruch 1, wobei:
das Ändern das Abscheiden von mindestens einem Zehntel der Sperrschicht (26) bei einer Drehzahl von nicht mehr als 10 U/min und mindestens einem Drittel der Sperrschicht bei einer Drehzahl von mindestens 12 U/min umfasst.

7. Verfahren nach einem der vorhergehenden Ansprüche, wobei:
die Sperrschicht (26) einen auf Seltenerdbasis stabilisierten Zirconiumanteil von mindestens 50 Gew.-% aufweist.

8. Verfahren nach einem der vorhergehenden Ansprüche, wobei:
die Sperrschicht (26) aus 7YSZ besteht.

9. Verfahren nach einem der vorhergehenden Ansprüche, ferner umfassend:
Auftragen einer Haftschicht (24) auf ein Substrat (22) der Komponente und wobei die Sperrschicht (26) oben auf der Haftschicht (24) aufgetragen wird.

10. Verfahren nach Anspruch 9, wobei:
das Auftragen der Haftschicht durch Niederdruckplasmaspritzen (LPPS) erfolgt.

11. Verfahren nach Anspruch 9, wobei:
das Auftragen der Haftschicht durch Niederdruckplasmaspritzen (LPPS) eines NiCoCrAlY-Materials erfolgt; und
das Auftragen der Sperrschicht durch Elektronenstrahlverdampfung (EBPVD) durch ein Material, umfassend mindestens 50 Gew.-% mit Yttriumoxid stabilisiertes Zirconiumoxid (YSZ), erfolgt.

12. Verfahren nach Anspruch 9, 10 oder 11, wobei die Sperrschicht (26) durch eine säulenförmige Mikrostruktur gekennzeichnet ist, die eine modulierte Dichte und Gerichtetheit aufweist und ferner umfassend:
Entfernen einer Ausgangswärmedämmbeschichtung, die eine Struktur aufweist, die durch eine säulenförmige Mikrostruktur mit konstanter Dichte und Gerichtetheit gekennzeichnet ist.

13. Vorrichtung (200), umfassend:
eine Befestigung (236) zum Halten einer Komponente (228);
einen Motor (230), der an die Befestigung (236) gekoppelt ist, zum Drehen der Befestigung (236) um eine Befestigungsachse (232);
eine Elektronenstrahlverdampfungsquelle (208) einer Keramik, die positioniert ist, um einen Dampf für die Komponente (228) an der Befestigung (236) bereitzustellen; und
eine Steuerung (234), die an den Motor (230) gekoppelt ist, um die Drehung zu steuern und konfiguriert ist, um eine Drehzahl zwischen einer niedrigen Rate und einer hohen Rate wechseln zu lassen, sodass ein Aufbau der Keramik an einer gegebenen Stelle an der Komponente (228) durch Durchgänge mit unterschiedlicher Drehzahl gebildet wird; **dadurch gekennzeichnet, dass** der Wechsel mindestens einmal pro Umdrehung auftritt.

## Revendications

1. Procédé de revêtement d'un composant de moteur à turbine à gaz (22), le procédé comprenant :
l'application d'un revêtement de barrière céramique (26) au moyen d'un dépôt physique en phase vapeur par faisceau d'électrons,
dans lequel l'application du revêtement de barrière (22) comprend :
la rotation du substrat (22) lorsque le revêtement de barrière (26) est appliqué ; et
la variation d'une vitesse de la rotation en alternant entre une vitesse faible et une vitesse élevée de sorte qu'une accumulation du revêtement de barrière à un emplacement donné sur le composant (228) est formée par des passages à une vitesse variée, **caractérisé en ce que**
l'alternance se produit au moins une fois par tour.

2. Procédé selon la revendication 1, dans lequel :
la vitesse faible ne dépasse pas 10 tr/min et la vitesse élevée est d'au moins 12 tr/min.

3. Procédé selon la revendication 1, dans lequel :
la vitesse élevée est de 2 à 10 fois la vitesse faible.

4. Procédé selon la revendication 3, dans lequel :
la vitesse faible se compose d'une seule vitesse dans une plage de 1 à 30 tr/min et la vitesse élevée se compose d'une seule vitesse dans une plage de 5 à 100 tr/min.

5. Procédé selon la revendication 3, dans lequel :
la rotation se compose de ladite vitesse faible et de ladite vitesse élevée.

6. Procédé selon la revendication 1, dans lequel :
la variation comprend le dépôt d'au moins un dixième du revêtement de barrière (26) à une vitesse de la rotation ne dépassant pas 10 tr/min et d'au moins un tiers du revêtement de barrière à une vitesse de la rotation d'au moins 12 tr/min.

7. Procédé selon une quelconque revendication précédente dans lequel :
le revêtement de barrière (26) a une teneur en zircone stabilisée à base de terres rares d'au moins 50 % en poids.

8. Procédé selon une quelconque revendication précédente, dans lequel :
le revêtement de barrière (26) se compose de 7YSZ.

9. Procédé selon une quelconque revendication précédente, comprenant en outre :
l'application d'un revêtement de liaison (24) sur un substrat (22) du composant et dans lequel le revêtement de barrière (26) est appliqué au-dessus du revêtement de liaison (24) .

10. Procédé selon la revendication 9, dans lequel :
l'application du revêtement de liaison se fait par projection plasma basse pression (LPPS).

11. Procédé selon la revendication 9, dans lequel :
l'application du revêtement de liaison se fait par projection plasma basse pression (LPPS) d'un matériau NiCoCrAlY ; et
l'application du revêtement de barrière par dépôt physique en phase vapeur par faisceau d'électrons (EBPVD) est constituée d'un matériau comprenant au moins 50 % en poids de zircone stabilisée à l'oxyde d'yttrium (YSZ).

12. Procédé selon la revendication 9, 10 ou 11, dans lequel le revêtement de barrière (26) est **caractérisé par** une microstructure en colonne ayant une densité et une directionnalité modulées et comprenant en outre :
l'élimination d'un revêtement de barrière thermique de base ayant une structure **caractérisée par** une microstructure en colonne de densité et de directionnalité constantes.

13. Appareil (200), comprenant :
une fixation (236) pour maintenir un composant (228) ;
un moteur (230) couplé à la fixation (236) pour faire tourner la fixation (236) autour d'un axe de fixation (232) ;
une source de dépôt physique en phase vapeur par faisceau d'électrons (208) d'une céramique positionnée pour fournir une vapeur au composant (228) sur la fixation (236) ; et
un dispositif de commande (234) couplé au moteur (230) pour commander la rotation et configuré pour alterner une vitesse de rotation entre une vitesse faible et une vitesse élevée de sorte qu'une accumulation de la céramique à un emplacement donné sur le composant (228) est formée par des passages à une vitesse variée ; **caractérisé en ce que** l'alternance se produit au moins une fois par tour.
